# EUROPEAN PATENT APPLICATION

(11) **EP 4 498 550 A1**
(43) Date of publication of application: **29.01.2025**
(21) Application number: 23188321.6
(22) Date of filing: 28.07.2023
(51) Int. Cl.: H02J 1/08

(54) **REDUNDANT ELECTRICAL GROUND SUPPLY SYSTEM**

(71) Applicant: Aptiv Technologies AG, 8200 Schaffhausen (CH)
(72) Inventor: ROSENTHAL, Thorsten, 45468 Mülheim an der Ruhr (DE); YOUSEF, Sebastian, 44795 Bochum (DE); FUCHS, Andreas, 51067 Köln (DE)
(74) Representative: Bardehle Pagenberg Partnerschaft mbB Patentanwälte Rechtsanwälte

(57) **Abstract**

The present invention relates to a redundant electrical ground supply system (1), comprising: a common electrical ground output (2) being configured to be electrically connected to or disconnected from a first electrical ground input (3a) and/or a second electrical ground input (3b); a first resistor (4a) being configured to be electrically connected to or disconnected from the first electrical ground input (3a) and/or a battery voltage (VBAT); and a second resistor (4b) being configured to be electrically connected to or disconnected from the second electrical ground input (3b) and/or a battery voltage (VBAT).

## Description

### Technical field

The present invention relates to a redundant electrical ground supply system and to a method of diagnosing a redundant electrical ground supply system.

### Technical background

Redundant power supplies are used in variety of applications ranging from critical computer systems to vehicles. The basis of a redundant power supply are two or more power sources connected in parallel. Even in case of a failure of one of the power sources, the other power source(s) would still be able to supply power to a load connected to the redundant power supply. In this way, redundancy improves the robustness, fail-safety and availability.

In addition to a redundant power supply, there is a desire to provide a redundant ground connection to critical systems as well. The ground connection of an electrical system is as critical as its connection to a power supply e.g., a (positive) battery voltage. Failure of the ground connection or a high contact resistance e.g., due to corrosion or a loose clamping connection, may cause a breakdown of the power supply to a critical system. Therefore, the ground connection of critical systems is often redundant as well i.e., the system is connected to multiple ground rails.

However, what is still needed is a way to monitor the status of a redundant ground connection and to be able to detect a possible failure in one of its sub-connections in order to initiate corresponding measures. At the same time, such additional safety measures shall be implemented with a minimum of additional components to reduce complexity and costs.

### Summary of the Invention

The present invention addresses those needs by the subject matter of the independent claims. Advantageous embodiments are defined in the dependent claims.

Accordingly, in a first aspect, the present invention relates to a redundant electrical ground supply system comprising a common electrical ground output being configured to be electrically connected to or disconnected from a first electrical ground input and/or a second electrical ground input; a first resistor being configured to be electrically connected to or disconnected from the first electrical ground input and/or a battery voltage; and a second resistor being configured to be electrically connected to or disconnected from the second electrical ground input and/or a battery voltage.

The first electrical ground input may be connected to a first ground rail and the second electrical ground input may be connected to a second ground rail. Thus, both ground rails may provide a ground potential to the electrical ground supply system. The redundant ground potential is provided at the common electrical ground output of the system according to the invention. In case of a proper operation of the system and the ground supply rails, the common electrical ground output is in electrical contact to at least two ground potentials with low contact resistance and provides a redundant ground potential e.g. to critical systems. It should be noted that the system according to the invention may comprise more than two ground inputs.

As both electrical ground inputs may individually be connected to or disconnected from the common ground output and as both resistors may individually be connected to or disconnected from the common ground output and/or the battery voltage, it is possible to diagnose whether the ground connection of both ground inputs is lost or the values of their contact resistances. In addition, it is possible to diagnose the state of diodes and switching elements of the system e.g., whether they are stuck open or closed. In this way, the system according to the invention provides a redundant electrical ground supply, wherein the system is diagnosable with respect to its ground inputs and its internal components.

The redundant electrical ground supply system according to the invention may further comprise a first switching element being configured to electrically connect or disconnect the common ground output to or from the first electrical ground input; and a second switching element being configured to electrically connect or disconnect the common ground output to or from the first electrical ground input. The switching elements allow to connect or disconnect the common ground output to and from the ground inputs. This allows to diagnose the state of the ground connections and to detect e.g., whether the ground connection of one of the ground inputs is lost. Such a loss of ground connection may be due to a failure of a mechanical connection, a torn cable, a broken solder joint, etc. It should be noted that in case of more than two ground inputs, the system according to the invention may comprise more than the first and second switching element.

The redundant electrical ground supply system according to the invention may further comprise a third switching element being configured to electrically connect or disconnect the first resistor to or from the first electrical ground input or the battery voltage; and a fourth switching element being configured to electrically connect or disconnect the second resistor to or from the second electrical ground input or the battery voltage. The third and fourth switching elements allow to connect or disconnect the resistors to and from its corresponding ground inputs. In this way, additional diagnostic information may be obtained by measuring the electrical potential at the resistors in defined states of the switching elements (open or close). For example, it is possible to diagnose the contact resistances of the ground connections and to diagnose the switching elements itself. It should be noted that in case of more than two ground inputs, the system according to the invention may comprise more switching elements to connect or disconnect the common ground output to or from the corresponding ground input.

The redundant electrical ground supply system according to the invention may further comprise a third resistor in series with the first resistor and the third switching element to form a voltage divider with the first resistor; and a fourth resistor in series with the second resistor and the fourth switching element to form a voltage divider with the second resistor. Using a voltage divider instead of a single resistor allows to obtain additional diagnostic information. For example, if the potential at the middle junction of the voltage divider is higher than an expected potential by a predetermined threshold, it may be deduced that the ground contact resistance of the corresponding ground input is too high. If, in contrast, the potential at the middle junction of the voltage divider is near oV, it may be deduced that the switch being in series with the voltage divider is stuck open.

The redundant electrical ground supply system according to the invention may further comprise a control unit configured to control states of first, second, third and fourth switching elements. Such a control unit may for example be a safety microcontroller unit having a certain safety qualification such as according to the Automotive Safety Integrity Level (ASIL) risk classification scheme. The control unit allows to automatically diagnose the system according to the invention by connecting and disconnecting ground inputs and resistors accordingly and measuring the potential of the battery voltage and at the resistors of the system to obtain diagnostic information. The diagnosis method may be implemented in the control unit by means of software.

The control unit may further be configured to measure the electrical potential of the battery voltage, at one end of the first resistor and at one end of the second resistor. In this way, the control unit obtains diagnostic information about the quality of the ground connections but also about the switches and diodes employed in the system.

The control unit may be configured to output a signal and/or to alter the content of a portion of a non-volatile memory in response to measuring an electrical potential that deviates from an expected electrical potential by a predetermined threshold after setting the states of the first (D1), second (D2), third (T1) and fourth (T2) switching elements to a predetermined configuration. This allows to indicate a possible failure to a user, driver and/or to another system. For example, in case the system of the invention is used in a vehicle, the signal may prevent starting the vehicle if the diagnosis is performed when the engine is off. Writing the result of the diagnosis to a non-volatile memory may be helpful for error diagnosis and maintenance. For example, a detected failure of one of the ground connections may be logged to a failure memory which may be read during maintenance such that the faulty ground connection can be repaired.

The redundant electrical ground supply system according to the invention may further comprise a limp home logic comprising at least one control input and being configured to provide defined electrical potentials to inputs of the first, second, third and fourth switching elements absent of defined electrical potential at its at least one control input. The limp home logic provides defined states to the switching elements of the system during startup and in case of a failure. This guarantees that the system provides a proper ground connection in all circumstances to the extent possible.

The at least one control input of the limp home logic may be electrically connected to at least one control output of the control unit. In this way, the control unit can control the states of the switching elements and perform a diagnosis of the system but in case of startup or a failure of the control unit, the limp home logic assures defined states of the switching elements and a proper connection of the common ground output to the ground inputs.

A further aspect of the present invention is directed to a method of diagnosing an electrical ground supply system of the present invention and as described herein. The method comprises the steps: disconnecting the common electrical ground output from the first electrical ground input; connecting the common electrical ground output to the second electrical ground input; disconnecting the first resistor from the first electrical ground input and/or from the battery voltage; disconnecting the second resistor from the second electrical ground input and/or from the battery voltage; and measuring the electrical potential between the battery voltage and the common ground output and/or measuring the electrical potential at the first resistor.

The method allows to diagnose whether the first switching element connecting or disconnecting the common ground output to the first ground input is stuck, whether the ground connection of the second ground input is lost or whether the third switching element connected to the first resistor is stuck conductive.

The method may further comprise the steps: disconnecting the common electrical ground output from the first electrical ground input and the second electrical ground input; disconnecting the first resistor from the first electrical ground input and/or from the battery voltage; disconnecting the second resistor from the second electrical ground input and/or from the battery voltage; and measuring the electrical potential between the battery voltage and the common ground output. This allows to diagnose whether one of the first switching element or the second switching element is stuck closed.

The method may further comprise the steps: connecting the common electrical ground output to the first electrical ground input; disconnecting the common electrical ground output from the second electrical ground input; connecting the first resistor to the first electrical ground input and to the battery voltage; connecting the second resistor to the second electrical ground input and to the battery voltage; and measuring the electrical potential at the first resistor. This allows to diagnose whether the third switching element connected to the first resistor is stuck open or whether the contact resistance of the first ground input is too high.

The method may further comprise the steps: connecting the common electrical ground output to the first electrical ground input; disconnecting the common electrical ground output from the second electrical ground input; disconnecting the first resistor from the first electrical ground input and/or from the battery voltage; disconnecting the second resistor from the second electrical ground input and/or from the battery voltage; and measuring the electrical potential between the battery voltage and the common ground output and/or measuring the electrical potential at the first resistor. This allows to diagnose whether the second switching element connecting or disconnecting the common ground output to the second ground input is stuck, whether the ground connection of the first ground input is lost or whether the fourth switching element connected to the second resistor is stuck conductive.

The method may further comprise the steps: disconnecting the common electrical ground output from the first electrical ground input; connecting the common electrical ground output to the second electrical ground input; connecting the first resistor to the first electrical ground input and to the battery voltage; connecting the second resistor to the second electrical ground input and to the battery voltage; and measuring the electrical potential at the second resistor. This allows to diagnose whether the fourth switching element connected to the second resistor is stuck open or whether the contact resistance of the second ground input is too high.

The invention also relates to a computer program comprising instructions which, when executed by a computer, cause the computer to perform a method as described herein.

### Brief Description of the Drawings

Possible embodiments of the invention are described in more detail in the following detailed description with reference to the following figure:

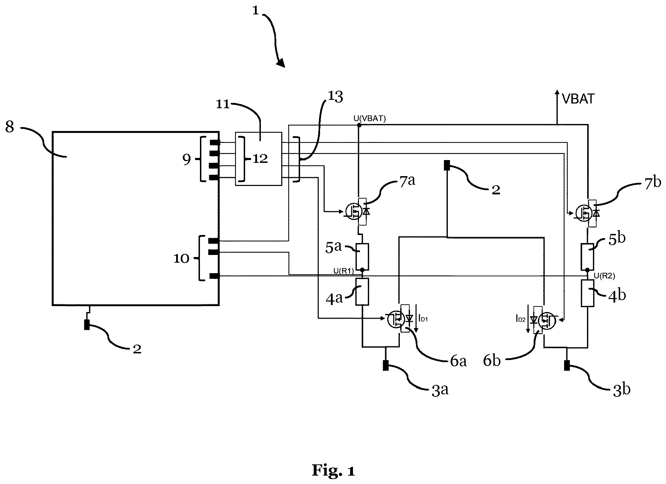

- Fig. 1: illustrates an exemplary embodiment of the present invention.

### Detailed Description of Possible Embodiments

For the sake of brevity, only a few embodiments will be described below. The person skilled in the art will recognize that the features described with reference to these specific embodiments may be modified and combined in different ways and that individual features may also be omitted. The general explanations in the sections above also apply to the more detailed explanations below.

Fig. 1 illustrates an exemplary embodiment of the present invention by way of a redundant electrical ground supply system 1. The system 1 comprises a common electrical ground output 2. The ground output 2 provides a redundant ground potential e.g., to critical systems such as systems on a chip (SoCs), microcontroller units (MCUs), ethernet switches and the like. Such critical systems may for example be employed in vehicles and may control critical functions such as adaptive cruise control, lane assistant, brake assistant and autonomous driving functions. The common ground output 2 also provides a ground potential for elements of the system 1 itself such as a control unit X which will be described in more detail below.

The common ground output 1 is configured to be electrically connected to or disconnected from a first electrical ground input 3a and/or a second electrical ground input 3b by corresponding switching elements 6a and 6b which will be described in more detail below. The ground inputs 3a and 3b are configured to be connected to corresponding ground rails, ground terminals, ground clamps, etc. To provide redundancy, the inputs 3a and 3b should be connected to different ground supplies e.g., ground rails.

The system 1 also comprises a first resistor 4a being configured to be electrically connected to or disconnected from a battery voltage (VBAT) and a second resistor being configured to be electrically connected to or disconnected from the battery voltage (VBAT). Instead of to the battery voltage (VBAT), the first or second resistor may alternatively be configured to be connected to or disconnected from the first electrical ground input 3a or the second electrical ground input 3b, respectively. The battery voltage VBAT can be supplied by a redundant power supply which comprises for example two independent power supply branches and achieves a high availability for safety-critical applications. The connection or disconnection of the first resistor 4a is accomplished by a third switching element 7a and the connection or disconnection of the second resistor 4b is accomplished by a fourth switching element 7b. The switching elements 7a and 7b will be described in more detail below.

In the embodiment of Fig. 1, the redundant electrical ground supply system 1 further comprises a third resistor 5a in series with the first resistor 4a and the third switching element 7a to form a voltage divider with the first resistor 4a. In addition, the system comprises a fourth resistor 5b in series with the second resistor 4b and the fourth switching element 7b to form a voltage divider with the second resistor 4b.

The switching elements 6a, 6b, 7a and 7b may be realized by field effect transistors FETs such as MOSFETs. In addition, the switching elements 6a and 6b may be realized as "ideal diodes" which have a lower voltage drop and leakage current compared to conventional MOSFETs. Moreover ideal diodes advantageously avoid compensating currents between both ground inputs 3a and 3b if one of those inputs comprises a bad ground connection due to e.g. a high contact resistance or even has lost ground contact. Each of the switching elements 6a, 6b, 7a and 7b comprises an input which allows to control the state of the switching element i.e., either conducting (on/open) or non-conducting (off/closed).

The redundant electrical ground supply system 1 according to the embodiment of Fig. 1 further comprises a control unit 8 configured to control states of first, second, third and fourth switching elements 6a, 6b, 7a and 7b, respectively. The control unit may for example be a safety microcontroller unit having a certain safety qualification such as according to the Automotive Safety Integrity Level (ASIL) risk classification scheme. The control unit may also be realized as an ASIC, a conventional microprocessor or the like.

To control the states of the switching elements 6a, 6b, 7a and 7b, the control unit comprises a plurality of outputs 9 which may operate at transistor-transistor logic (TTL) voltage levels or complementary metal-oxide-semiconductor (CMOS) voltage levels. The control unit 8 further comprises inputs 10 which are configured to measure the electrical potential between the battery voltage (VBAT) and ground 2, the potential (U(R1)) at a middle junction of the first voltage divider formed by resistors 4a and 5a and the potential (U(R2)) at a middle junction of the second voltage divider formed by resistors 4b and 5b. To this end, the control unit may comprise analog-to-digital converters (ADCs). Alternatively, the ADCs may be one or more separate components and may output the measured potentials to the control unit 8 in a digital format. Also, amplifiers, such as differential amplifiers, may be arranged between the measuring points and the ADCs or the control unit 8 to amplify the voltage to be measured and/or to provide for impedance matching.

The control unit 8 may be configured to output a signal (not shown in Fig. 1) and/or to alter the content of a portion of a non-volatile memory (not shown in Fig. 1) in response to measuring an electrical potential that deviates from an expected electrical potential by a predetermined threshold after setting the states of the first 6a, second 6b, third 7a and fourth 7b switching elements to a predetermined configuration. The non-volatile memory may be a EEPROM or similar device and may be internal or external to the control unit 8. The signal may be provided to another control unit and/or a visual and/or optical alarm means.

The redundant electrical ground supply system 1 according to the embodiment of Fig. 1 further comprises a limp home logic 11 comprising a plurality of control inputs 12 which are connected to corresponding outputs 9 of the control unit 8. The limp home logic 11 comprises corresponding outputs 13 which are connected to the inputs of the first 6a, second 6b, third 7a and fourth 7b switching elements. Accordingly, the limp home logic 11 defines the states (on/off) of the switching elements. The limp home logic 11 provides defined electrical potentials to the inputs of the first 6a, second 6b, third 7a and fourth 7b switching elements absent of defined electrical potentials at its inputs 12. To this end, the limp home logic 11 may employ pull-up or pull-down resistors which pull its outputs 13 to a defined electrical potential. In a normal operation, the states of the outputs 13 of the limp home logic correspond to the states of the outputs 9 of the control unit 8. Thus, the control unit 8 is able to control the states (on/off) of the switching elements 6a, 6b, 7a and 7b. During start-up or reset of the control unit 8 its outputs 9 are advantageously in a neutral state (e.g., open, high resistance or "tristate") so that the limp home logic 11 can pull the control inputs of the switching elements 6a, 6b, 7a and 7b to defined potentials and the common ground output 2 is electrically connected to both ground inputs 3a and 3b.

In the following, it is described how the control unit 8 diagnoses the redundant electrical ground supply system 1 according to the embodiment of Fig. 1 by setting its outputs 9 and measuring the electrical potentials at its inputs 10. The following example assumes that the system 1 according to the invention is employed in a car but the invention is not limited to be applied to cars. Furthermore, it is assumed that the mentioned voltage dividers comprise resistors of equal value such that the potential at the middle junctions is half the input voltage to the dividers. The invention is not limited to such a resistance ratio.

The following table shows with respect to the embodiment of Fig. 1 how the first 3a and second 3b ground inputs and switching elements 6a, 6b and 7a can be diagnosed with the method according to the invention:

| Test no. | Pre-condition | Test case | Pass criteria | Fail criteria | Detected root cause |
|---|---|---|---|---|---|
| 1 | Car parked, engine OFF, ignition 0 -> 1, switch 6a ON, switch 6b ON, switch 7a OFF, switch 7b OFF. | Switch 6a OFF. | No change in voltage measurement of battery voltage (VBAT). | Ground output 2 increased by forward voltage of bulk diode. Voltage measurement of VBAT to ground output 2 decreased by voltage over bulk diode. | Switch 6b stuck open or ground input 3b lost ground connection. |
| 2 | | Measure Voltage U(R1) at voltage divider 4a/5a. | Approx. 0V. | Approx. VBAT/2. | Switch 7a stuck conductive. |
| 3 | Car parked, engine OFF, ignition 0 -> 1, switch 6a OFF, switch 6b ON, switch 7a OFF, switch 7b OFF | Switch 6b OFF. | Internal GND potential increased by forward voltage of bulk diodes. Voltage measurement of VBAT to GND is decreased by voltage over bulk diode. | No change in voltage measurement of VBAT. | Switches 6a or 6b stuck closed. |
| 4 | Car parked, engine OFF, ignition 0 -> 1, switch 6a OFF, switch 6b OFF, switch 7a OFF, switch 7b OFF | Switch 6a ON, Switch 6b ON, Switch 7a ON, Measure Voltage U(R1). | Approx. VBAT/2. | Voltage U(R1) at voltage divider 4a/5a approx. 0V. | Switch 7a stuck open. |
| 5 | | | | Voltage U(R1) at voltage divider 4a/5a over threshold (>VBAT/2) | Contact resistance of ground input 3a too high. |

The following table shows with respect to the embodiment of Fig. 1 how the first 3a and second 3b ground inputs and switching elements 6a, 6b and 7b can be diagnosed with the method according to the invention:

| Test no. | Pre-condition | Test case | Pass criteria | Fail criteria | Detected root cause |
|---|---|---|---|---|---|
| 1 | Car parked, engine OFF, ignition 0 -> 1, switch 6a ON, switch 6b ON, switch 7a OFF, switch 7b OFF. | Switch 6b OFF. | No change in voltage measurement of battery voltage (VBAT). | Ground output 2 increased by forward voltage of bulk diode. Voltage measurement of VBAT to ground output 2 decreased by voltage over bulk diode. | Switch 6a stuck open or ground input 3a lost ground connection. |
| 2 | | Measure Voltage U(R2) at voltage divider 4b/5b. | Approx. 0V. | Approx. VBAT/2. | Switch 7b stuck conductive. |
| 3 | Car parked, engine OFF, ignition 0 -> 1, switch 6a ON, switch 6b OFF, switch 7a OFF, switch 7b OFF | Switch 6a OFF. | Internal GND potential increased by forward voltage of bulk diodes. Voltage measurement of VBAT to | No change in voltage measurement of VBAT. | Switches 6a or 6b stuck closed. |
| | | | GND is decreased by voltage over bulk diode. | | |
| 4 | Car parked, engine OFF, ignition 0 -> 1, switch 6a OFF, switch 6b OFF, switch 7a OFF, switch 7b OFF | Switch 6a ON, Switch 6b ON, Switch 7b ON, Measure Voltage U(R2). | Approx. VBAT/2. | Voltage U(R2) at voltage divider 4b/5b approx. 0V. | Switch 7b stuck open. |
| 5 | | | | Voltage U(R2) at voltage divider 4b/5b over threshold (>VBAT/2) | Contact resistance of ground input 3b too high. |

As shown in both tables, the quality of the ground connections of both ground inputs 3a and 3b as well as the proper functioning of the switching elements can be diagnosed with the method according to the invention by setting the states of the switching elements accordingly and measuring the response of the electrical potentials at the three test points VBAT, U(R1) and U(R2). If the measured potentials do not match the expected values, a failure condition is detected. The described self-test can be performed in an uncritical or safe state, e.g. in case of a vehicle when the vehicle is parked and the ignition is off.

The self-test described above may be performed by the control unit 8 described herein which may be microcontroller, ASIC or similar device. To this end, the method of diagnosing the redundant electrical ground supply system 1 as disclosed herein may be implemented in hardware or in software or may be implemented partly in hardware and partly in software. Hardware suitable for implementing a method and an apparatus according to the present invention include a central processing unit (CPU), a microcontroller, an application-specific integrated circuit (ASIC) or the like. A (full or partial) software implementation may include compiling source code to obtain machine readable instructions which, when executed, cause a computer, CPU, microcontroller or the like to perform all or part of the method steps described herein.

## Claims

1. Redundant electrical ground supply system (1), comprising:
a common electrical ground output (2) being configured to be electrically connected to or disconnected from a first electrical ground input (3a) and/or a second electrical ground input (3b);
a first resistor (4a) being configured to be electrically connected to or disconnected from the first electrical ground input (3a) and/or a battery voltage (VBAT); and
a second resistor (4b) being configured to be electrically connected to or disconnected from the second electrical ground input (3b) and/or a battery voltage (VBAT).

2. Redundant electrical ground supply system (1) according to claim 1, further comprising:
a first switching element (6a) being configured to electrically connect or disconnect the common ground output (2) to or from the first electrical ground input (3a); and
a second switching element (6b) being configured to electrically connect or disconnect the common ground output (2) to or from the first electrical ground input (3b).

3. Redundant electrical ground supply system (1) according to claim 1 or 2, further comprising:
a third switching element (7a) being configured to electrically connect or disconnect the first resistor (4a) to or from the first electrical ground input (3a) or the battery voltage (VBAT); and
a fourth switching element (7b) being configured to electrically connect or disconnect the second resistor (4b) to or from the second electrical ground input (3b) or the battery voltage (VBAT).

4. Redundant electrical ground supply system (1) according to claim 3, further comprising:
a third resistor (5a) in series with the first resistor (4a) and the third switching element (7a) to form a voltage divider with the first resistor (4a); and
a fourth resistor (5b) in series with the second resistor (4b) and the fourth switching element (7b) to form a voltage divider with the second resistor (4b).

5. Redundant electrical ground supply system (1) according to claim 3 or 4 when dependent on claim 2, further comprising:
a control unit 8 configured to control states of first (6a), second (6b), third (7a) and fourth (7b) switching elements.

6. Redundant electrical ground supply system (1) according to claim 5,
wherein the control unit 8 is further configured to measure the electrical potential of the battery voltage (VBAT), at one end of the first resistor (4a) and at one end of the second resistor (4b).

7. Redundant electrical ground supply system (1) according to claim 6,
wherein the control unit 8 is configured to output a signal and/or to alter the content of a portion of a non-volatile memory in response to measuring an electrical potential that deviates from an expected electrical potential by a predetermined threshold after setting the states of the first (6a), second (6b), third (7a) and fourth (7b) switching elements to a predetermined configuration.

8. Redundant electrical ground supply system (1) according to one of claims 3-7 when dependent on claim 2, further comprising:
a limp home logic 11 comprising at least one control input 12 and being configured to provide defined electrical potentials to inputs of the first (6a), second (6b), third (7a) and fourth (7b) switching elements absent of a defined electrical potential at its at least one control input 12.

9. Redundant electrical ground supply system (1) according to claim 8 when dependent on one of claims 5-7, wherein the at least one control input 12 of the limp home logic 8 is electrically connected to at least one control output 9 of the control unit 8.

10. Method of diagnosing an electrical ground supply system (1) according to one of claims 1-9, comprising the steps:
disconnecting the common electrical ground output (2) from the first electrical ground input (3a);
connecting the common electrical ground output (2) to the second electrical ground input (3b);
disconnecting the first resistor (4a) from the first electrical ground input (3a) and/or from the battery voltage (VBAT);
disconnecting the second resistor (4b) from the second electrical ground input (3b) and/or from the battery voltage (VBAT); and
measuring the electrical potential between the battery voltage (VBAT) and the common ground output (2) and/or measuring the electrical potential at the first resistor (4a).

11. Method according to claim 10, further comprising the steps:
disconnecting the common electrical ground output (2) from the first electrical ground input (3a) and the second electrical ground input (3b);
disconnecting the first resistor (4a) from the first electrical ground input (3a) and/or from the battery voltage (VBAT);
disconnecting the second resistor (4b) from the second electrical ground input (3b) and/or from the battery voltage (VBAT); and
measuring the electrical potential between the battery voltage (VBAT) and the common ground output (2).

12. Method according to claim 10 or 11, further comprising the steps:
connecting the common electrical ground output (2) to the first electrical ground input (3a);
disconnecting the common electrical ground output (2) from the second electrical ground input (3b);
connecting the first resistor (4a) to the first electrical ground input (3a) and to the battery voltage (VBAT);
connecting the second resistor (4b) to the second electrical ground input (3b) and to the battery voltage (VBAT); and
measuring the electrical potential at the first resistor (4a).

13. Method according to one of claims 10-12, further comprising the steps:
connecting the common electrical ground output (1) to the first electrical ground input (3a);
disconnecting the common electrical ground output (1) from the second electrical ground input (3b);
disconnecting the first resistor (4a) from the first electrical ground input (3a) and/or from the battery voltage (VBAT);
disconnecting the second resistor (4b) from the second electrical ground input (3b) and/or from the battery voltage (VBAT); and
measuring the electrical potential between the battery voltage (VBAT) and the common ground output (1) and/or measuring the electrical potential at the first resistor (4a).

14. Method according to one of claims 10-13, further comprising the steps:
disconnecting the common electrical ground output (2) from the first electrical ground input (3a);
connecting the common electrical ground output (2) to the second electrical ground input (3b);
connecting the first resistor (4a) to the first electrical ground input (3a) and to the battery voltage (VBAT);
connecting the second resistor (R2b) to the second electrical ground input (3b) and to the battery voltage (VBAT); and
measuring the electrical potential at the second resistor (4b).

15. Computer program comprising instructions which, when executed by a computer, cause the computer to perform a method of one of claims 10-14.
